# EUROPEAN PATENT APPLICATION

(11) **EP 4 116 719 A1**
(43) Date of publication of application: **11.01.2023**
(21) Application number: 21184687.8
(22) Date of filing: 09.07.2021
(51) Int. Cl.: G01R 31/327

(54) **MODULAR CIRCUIT BREAKER MONITORING SYSTEM FOR MONITORING A PARAMETER OF A HIGH VOLTAGE CIRCUIT BREAKER**

(71) Applicant: Hitachi Energy Switzerland AG, 5400 Baden (CH)
(72) Inventor: MERKERT, Lennart, 69115 Heidelberg (DE); WANG, David-Jing, Beijing, 100176 (CN); SCHULZE-KOENIG, Tim, 69115 Heidelberg (DE); SEHESTEDT, Stephan, 68165 Mannheim (DE); WALTER, Sandra, 68526 Ladenburg (DE); KROEGER, Timo, 68165 Mannheim (DE); KULATHUNGA, Suranga, 68723 Schwetzingen (DE)
(74) Representative: Michalski Hüttermann & Partner Patentanwälte mbB

(57) **Abstract**

The invention relates to a modular circuit breaker monitoring system for monitoring a parameter of a high voltage circuit breaker (1), comprising at least one stack of modules, each stack comprising
a control and communication module, CCM, (2) comprising a CPU, a data storage, and a CCM control area network, CAN, interface (3), and
at least one input module, IM, (4) configured for monitoring the parameter of the circuit breaker (1) and comprising an IM CAN interface (5), whereby
the CCM (2) and the at least one IM (4) are electrically connected via the CCM CAN interface (3) and the IM CAN interface (5), and are galvanically and locally separated.

## Description

### Technical Field

The invention relates to a circuit breaker monitoring system for monitoring a parameter of a high voltage circuit breaker, comprising at least one stack of modules, each stack comprising a control and communication module, CCM, comprising a CPU, a data storage, and a CCM control area network, CAN, interface.

### Background Art

Circuit breakers are important assets in high voltages. As high reliability is very important, a circuit breaker monitoring system allows to prewarn in case of upcoming failure and enables maintaining the circuit breaker just when required.

Maintenance of circuit breakers is usually done on a time-based schedule. Compared thereto, circuit breaker monitoring allows for switching to a condition-based monitoring mode, which increases reliability while in turn decreasing maintenance costs. However, prior art circuit breaker monitoring systems are deemed inflexible and not reliable.

### Summary of invention

It is therefore an object of the invention to provide an improved circuit breaker monitoring system.

The object of the invention is solved by the features of the independent claim. Preferred implementations are detailed in the dependent claims.

Thus, the object is solved by a modular circuit breaker monitoring system for monitoring a parameter of a high voltage circuit breaker, comprising at least one stack of modules, each stack comprising
a control and communication module, CCM, comprising a CPU, a data storage, and a CCM control area network, CAN, interface, and
at least one input module, IM, configured for monitoring the parameter of the circuit breaker and comprising an IM CAN interface, whereby
the CCM and the at least one IM are electrically connected via the CCM CAN interface and the IM CAN interface, and are galvanically and locally separated.

A key aspect of the proposed solution is that the at least one IM monitors, in particular measures, the parameter, which parameter is then submitted via the CAN to the CCM, where the parameter can be stored and/or calculated. Thereby the system utilizes a modularized set up, where the CCM and all IMs form a stack of said modules, while the system may comprise a plurality of such stacks. Thus, the overall system may comprise a plurality of circuit breakers, whereby one stack comprising a dedicated CCM and at least one or a plurality of IMs is associated to each circuit breaker.

The term modules respectively modular should preferably understood as that the CCM and the IMs are provided as separate units being electronically connected in particular only via the CAN for information exchange, while being galvanically and locally separated, thus for example, except for the CAN, in terms of information and/or power sharing between the modules. Thus, the term modules respectively modular may be understood that the CCM and the IMs do not communicate via an internal bus for example directly between the CCM and the IMs via a DIN rail, but rather via CAN. Due to the modularized approach the system can be easily installed and/or configured for different monitoring needs. The proposed solution thus provides reliable early warnings for example on SF6 leakages and forecasting features for critical levels of such circuit breakers.

The term parameter shall preferably understood as being compliant with for example IEEE C37.10.1-2018 - IEEE Guide for the Selection of Monitoring for Circuit Breakers, published 9 May 2019, in any earlier or future version, describing a selection of monitoring and diagnostic parameters to be used with high-voltage circuit breakers and/or being associated to a status, in particular switching status, of the circuit breaker. In this respect the term high voltage should preferably understood that the circuit breaker is configured for switching voltages above 1000 V. The CAN interface, also of the at least one IM, is preferably provided as per standard CAN 2.0A or CAN 2.0B, in particular according to CAN standard ISO 11898 including ISO 11898-1, ISO 11898-2 and/or ISO 11898-3.

The modular circuit breaker monitoring system is preferably used for a gas-insulated switchgear, GIS, comprising the circuit breaker and configured for operating in a medium voltage regime of 10 kV to 100 kV and/or in a high voltage regime of 100 kV to 1200 kV. The modular circuit breaker monitoring system may thus constitute an add-on system to, for example, supervise SF6 density inside a GIS. The proposed system can be applicable for retrofit of existing substations and for new installations. In sum, the proposed system improves availability of the complete switchgear by on-line monitoring of SF6 density in all gas compartments of the GIS by ensuring an early detection of critical situations and scheduling of countermeasures into non-critical times. The proposed system further supports maintenance planning by calculation of leakage trend such that inspection work can be significantly reduced and maintenance costs can be reduced by improved maintenance planning.

According to a preferred implementation the CPU is configured for calculating a status parameter of the circuit breaker based on the parameter received from the IM. Thus, the CPU is preferably configured for calculating the status parameter based on a measured parameter of the circuit breaker, in particular for determining the status of the circuit breaker. The calculation may include processing said parameter for calculating curves with timing information as status changes over time of the circuit breaker. The status parameter may include circuit breaker timing, speed and travel curve for identifying performance deterioration of circuit breaker, coil current analysis for indicating health status of an operating mechanism and its operating condition of the circuit breaker, phase current monitoring for recording current waveform during operation of the circuit breaker, fault operation counter for indicating aging of the circuit breaker, contact wear for computing contact erosion of the circuit breaker, unforced motor starts per day und motor current for identifying leakages in a hydraulic system of the circuit breaker, motor runtime for identifying wear an friction in a charging system of the circuit breaker and/or total motor starts counter for indicating wear of the motor of the circuit breaker. The CPU can be provided as a microprocessor or microcontroller known from prior art. The data storage can be provided as a memory known from prior art.

In another preferred implementation the CCM comprises at least one binary output for outputting a warning, an alarm and/or watchdog output based on the parameter received from the IM. The CCM may further comprise an internal clock, in particular comprising a means for clock synchronisation. The CCM is preferably configured to communicate with communication protocols such as IEC 61850 (MMS), DNP3.0, SNTP, SFTP and/or HTTP. Further, the CCM and the at least one IM are preferably provided DIN-rail mountable.

According to a further preferred implementation the at least one IM comprises an analogue current input, for example the slow update rate and fast update rate, an analogue voltage input, for example the fast update rate, a power supply for a sensor for monitoring the parameter, for example having multiple voltage levels such as +/- 5V, +12V, +/- 15V, +24V, a binary input, for example with separate isolation and/or ground, in particular being able for high voltages, a serial interface, an encoder input and/or a HMI interface for visualisation of alarms and/or parameters.

In this respect and according to another preferred implementation the at least one IM is provided as an Analog Input Module, as a Binary Input Module or as a Fast Analog Input Module. The analogue current input may be in a range between 0 to 20 mA, whereby a plurality of channels, for example 8 channels, can be provided. The binary input may comprise 6 channels, for example for monitoring of auxiliary switches, in particular for circuit breaker timing, and/or motor timing of the circuit breaker. The Fast Analog Input Module may comprise four inputs between 0 to 20 mA and/or +/- 5V, for example for monitoring of motor currents, trip and/or close coil currents and/or phase currents of the circuit breaker, in particular via a hall-effect sensor. The HMI can be provided for example as a LCD display attachable to the IM.

According to a further preferred implementation the modular circuit breaker monitoring system comprises at least one sensor connected to the at least one IM. The sensor is preferably configured to measure at least one operational parameter of the circuit breaker and is operatively connected to the at least one IM. In particular preferred implementation the sensor is provided as gas pressure sensor, as gas humidity sensor, as gas temperature sensor, as ambient temperature sensor, as current sensor, as voltage sensor, as rotary encoder and/or potentiometer sensor and/or as binary input sensor.

The gas pressure sensor is preferably provided as a Sulfur hexafluoride, SF6, sensor. The current sensor may include a hall sensor and/or the digital interface for sensing the current. The current sensor may measure a coil current, a motor and/or pump current and/or a phase current of the circuit breaker. The rotary encoder and/or potentiometer sensor may include a linear potentiometer are other measurement devices for linear or rotatably movement of moving parts of the circuit breaker. The binary input sensor may be connected to measure a state of an auxiliary contact of the circuit breaker or if the voltage of the circuit breaker is available. Generally, the sensor or are plurality of sensors can be configured to record individual measurements, curves and/or state changes with timing information.

In another preferred implementation the CCM and the at least one IM comprise preferably each a housing locally separated from each other. The housings are preferably arranged distant from each other, for example by at least one meter from each other and/or made of metal or plastic. The term locally separated is preferably understood that the CCM and the IMs are arranged locally distant from each other and that information exchange is in particular not performed directly between the CCM and the IMs, as known from prior art. Thus, the CCM and the IMs are preferably not arranged in a touching manner side-by-side and/or without electrical contacts for information exchange via housing to housing contacts.

According to a further preferred implementation the at least one IM comprises at least one of a microcontroller, an analogue-to-digital converter, a filtering circuit, a rectifier and/or a signal processing circuit. With such circuitry a sensor signal can be converted for being send as parameter via the IM CAN interface to the CCM.

In another preferred implementation the CCM comprises a HMI interface, in particular a web-based HMI interface connected to the CCM via the CAN interface. Thus, the HMI interface can be part of the CCM or connected thereto via the CAN interface. The HMI interface can be provided, for example, as display or more generally as graphical user interface for displaying the parameter and/or the status parameter.

According to a further preferred implementation the CCM comprises an CCM Ethernet interface configured for connecting a HMI interface, in particular a web-based HMI interface, and/or a remote supervisory control and data acquisition, SCADA, control system. The CCM Ethernet interface is preferably provided in accordance with IEEE-Norm 802.3. The HMI interface can be provided for example as display. A SCADA control system is generally understood as a control system architecture comprising computers, networked data communications and/or graphical user interfaces for high-level process supervisory management, while also comprising other peripheral devices like programmable logic controllers and/or discrete proportional-integral-derivative controllers, such as for example the CCM, to interface with process plant or machinery, such as the circuit breaker.

### Brief description of drawings

These and other aspects of the invention will be apparent from and elucidated with reference to the implementations described hereinafter.

In the drawings:

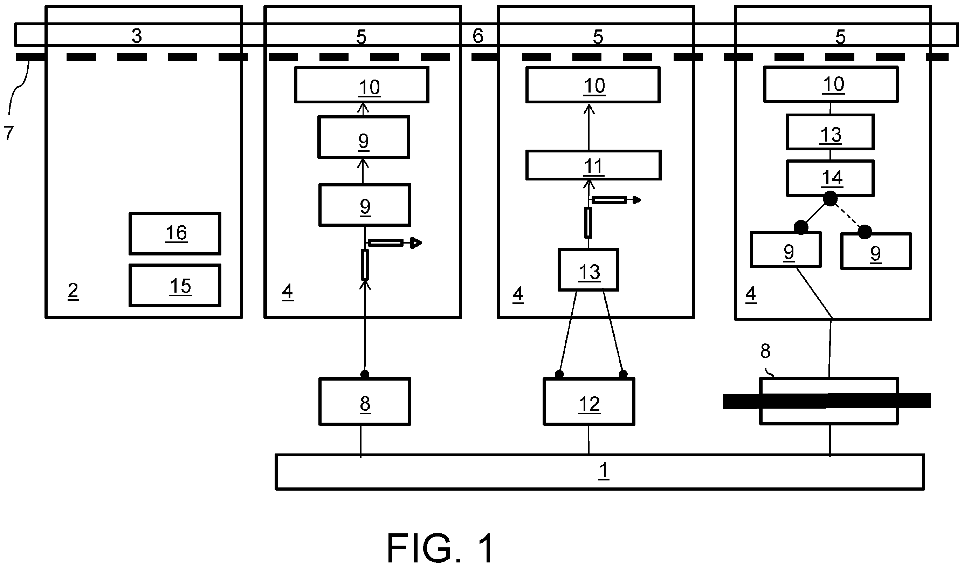

Fig. 1 shows a modular circuit breaker monitoring system for monitoring a parameter of a high voltage circuit breaker according to a preferred implementation in a schematic view.

### Description of implementations

Fig. 1 shows a modular circuit breaker monitoring system for monitoring a parameter of a high voltage circuit breaker 1, only schematically depicted, according to a preferred implementation in a schematic view.

The modular circuit breaker monitoring system comprises a control and communication module, CCM, 2 having a CPU in form of a not depicted microprocessor, a data storage in form of a not depicted memory, and a CCM control area network, CAN, interface 3. The system further comprises three input modules, IM, 4, for monitoring a parameter of the circuit breaker 1. The IMs 4 are provided, in order from left side to right side, as an Analog Input Module, a Binary Input Module and a Fast Analog Input Module.

Each IM 4 has an IM CAN interface 5 so that the CCM 2 and all IMs 4 are electronically connected via a CAN 6. In this respect the CCM 2 and all IMs 4 are galvanically and locally separated, indicated by dotted line 7. This means that information between the CCM 2 and all IMs 4 is not exchanged for example between electrical contacts connecting one IM 4 directly to another IM 4 as in prior art but rather only via CAN 6 such that a digital and power isolation is provided between the CCM 2 and all IMs 4.

As can be seen for the IM 4 on the outmost left side, a sensor 8 for monitoring a SF6 density of the circuit breaker 1 is connected to the Analog Input Module 4. The SF6 density as input parameter in form of a current in the range between 0 to 20 mA is processed within the IM 4 by a signal processing circuit 9, then converted by an analogue-to-digital converter of the microcontroller 10 of the IM 4 and finally send via the IM CAN interface 5 to the CCM 2. The Analog Input Module 4 may therefore comprise a second signal processing circuit 9 and a resistor circuitry, not referenced in Fig. 1. The sensor 8 can also be provided as as gas humidity sensor, as gas temperature sensor, as ambient temperature sensor, as current sensor, as voltage sensor, as rotary encoder and/or potentiometer sensor and/or as binary input sensor.

The middle IM 4 in Fig. 1 is provided as Binary Input Module, also comprising a microcontroller 10 receiving a binary signal from an integrated circuit 11, which provides additional digital isolation. The Binary Input Module 4 is fed by an AC/DC input voltage 12 which is indicative of a binary status of a switch and/or an auxiliary switch and/or an on-off status of the circuit breaker 1. The AC/DC input voltage 12 is rectified by a rectifier 13 and fed via a resistor circuitry, not referenced in Fig. 1, towards the integrated circuit 11.

The upmost right IM 4 in Fig. 1 is provided as Fast Analog Input Module, having an analogue-to-digital converter of the microcontroller 10, being fed by filtering circuit 13 and switch 14 having two signal processing circuits 9, one for +/- 5V and the other one for 0 to 20 mA input. As sensor 8 a hall-effect sensor is provided for measuring a phase current, coil current and/or motor current of the circuit breaker 1. Besides that each of the IMs 4 may comprise an analogue current input, an analogue voltage input, a power supply for a sensor for monitoring the parameter, a binary input, a serial interface, an encoder input and/or a HMI interface for visualisation of alarms and/or parameters.

The CCM 2 calculates via its CPU a status parameter of the circuit breaker based on the parameter received from the IM 4. The calculation may include processing said parameter for calculating curves with timing information as status changes over time of the circuit breaker. The status parameter may include circuit breaker timing, speed and travel curve for identifying performance deterioration of circuit breaker, coil current analysis for indicating health status of an operating mechanism and its operating condition of the circuit breaker, phase current monitoring for recording current waveform during operation of the circuit breaker, fault operation counter for indicating aging of the circuit breaker, contact wear for computing contact erosion of the circuit breaker, unforced motor starts per day und motor current for identifying leakages in a hydraulic system of the circuit breaker, motor runtime for identifying wear an friction in a charging system of the circuit breaker and/or total motor starts counter for indicating wear of the motor of the circuit breaker. The status parameter is then outputted via a binary output 15 of the CCM 2 as warning or alarm.

The CCM 2 and each of the IM 4 comprise a housing 2, 4 being each arranged locally separated from each other. While Fig. 1 shows only one stack of CCM 2 and IM 4 modules, the monitoring system may comprise a plurality of such stacks. The CCM 2 may also comprise a web-based HMI interface 16 for displaying the parameter and/or the status parameter. An additional HMI interface can be connected to the CCM 2 via the CAN interface 3, in particular galvanically separated. In addition the CCM 2 may comprise a CCM Ethernet interface 3, being configured for connecting a HMI interface 16, for communicating with another stack and/or for communicating with a remote supervisory control and data acquisition, SCADA, control system.

While the invention has been illustrated and described in detail in the drawings and foregoing description, such illustration and description are to be considered illustrative or exemplary and not restrictive; the invention is not limited to the disclosed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: circuit breaker
- 2: control and communication module, CCM; housing
- 3: CCM control area network, CAN, interface; CCM Ethernet interface
- 4: input module, IM; housing
- 5: IM CAN interface
- 6: CAN
- 7: dotted line
- 8: sensor
- 9: signal processing means
- 10: microcontroller
- 11: integrated circuit
- 12: AC/DC input voltage
- 13: rectifier
- 14: switch
- 15: binary output
- 16: HMI interface

## Claims

1. Modular circuit breaker monitoring system for monitoring a parameter of a high voltage circuit breaker (1), comprising at least one stack of modules, each stack comprising
a control and communication module, CCM, (2) comprising a CPU, a data storage, and a CCM control area network, CAN, interface (3), and
at least one input module, IM, (4) configured for monitoring the parameter of the circuit breaker (1) and comprising an IM CAN interface (5), whereby
the CCM (2) and the at least one IM (4) are electrically connected via the CCM CAN interface (3) and the IM CAN interface (5), and are galvanically and locally separated.

2. Modular circuit breaker monitoring system according to the previous claim, whereby the CPU is configured for calculating a status parameter of the circuit breaker (1) based on the parameter received from the IM (4).

3. Modular circuit breaker monitoring system according to any of the previous claims, whereby the CCM (2) comprises at least one binary output (15) for outputting a warning, an alarm and/or watchdog output based on the parameter received from the IM (4).

4. Modular circuit breaker monitoring system according to any of the previous claims, whereby the at least one IM (4) comprises an analogue current input, an analogue voltage input, a power supply for a sensor for monitoring the parameter, a binary input, a serial interface, an encoder input and/or a HMI interface (16) for visualisation of alarms and/or parameters.

5. Modular circuit breaker monitoring system according to any of the previous claims, whereby the at least one IM (4) is provided as an Analog Input Module, as a Binary Input Module or as a Fast Analog Input Module.

6. Modular circuit breaker monitoring system according to any of the previous claims, comprising at least one sensor (8) connected to the at least one IM (4).

7. Modular circuit breaker monitoring system according to the previous claim, whereby the sensor (8) is provided as gas pressure sensor, as gas humidity sensor, as gas temperature sensor, as ambient temperature sensor, as current sensor, as voltage sensor, as rotary encoder and/or potentiometer sensor and/or as binary input sensor.

8. Modular circuit breaker monitoring system according to any of the previous claims, whereby the CCM (2) and the at least one IM (4) each comprise a housing (2, 4) locally separated from each other.

9. Modular circuit breaker monitoring system according to any of the previous claims, whereby the at least one IM (4) comprises at least one of a microcontroller (10), an analogue-to-digital converter, a filtering circuit, a rectifier (13) and/or a signal processing circuit (9).

10. Modular circuit breaker monitoring system according to any of the previous claims, whereby the CCM (2) comprises a HMI interface (16) connected to the CCM (2) via the CCM CAN interface (3).

11. Modular circuit breaker monitoring system according to any of the previous claims, whereby the CCM (2) comprises an CCM Ethernet interface (3) configured for connecting a HMI interface (16), in particular a web-based HMI interface (16), for communicating with another stack and/or for communicating with a remote supervisory control and data acquisition, SCADA, control system.
